# EUROPÄISCHE PATENTANMELDUNG

(11) **EP 0 756 323 A2**
(43) Veröffentlichungstag der Anmeldung: **29.01.1997**
(21) Anmeldenummer: 96111074.9
(22) Anmeldetag: 10.07.1996
(51) Int. Cl.: H01L 23/485, H01L 21/60, H01L 21/58

(54) **Elektrische Leiter aufweisender Träger mit einem elektronischen Bauteil**

(30) Priorität: 28.07.1995 DE 19527661
(71) Anmelder: OPTREX EUROPE GmbH, 65760 Eschborn (DE)
(72) Erfinder: Fritz, Bernd, 63939 Wörth (DE); Salzmann, Timm, 64850 Schaafheim 2 (DE)
(74) Vertreter: Klein, Thomas, Dipl.-Ing. (FH)

(57) **Zusammenfassung**

Zum Kontaktieren von Leitern eines Trägers mit Kontaktwarzen eines elektronischen Bauteils werden zunächst die Kontaktwarzen an ihrer dem Träger zugewandten Seite mit einem im ausgehärteten Zustand elastisch bleibenden Graphitmaterial beschichtet. Dann bringt man Kleber auf das elektronische Bauteil zwischen den Kontaktwarzen oder entsprechend auf den Träger auf. Anschließend preßt man das elektronische Bauteil unter Vorspannung so lange auf den Träger, bis der Kleber ausgehärtet ist.

## Beschreibung

Die Erfindung betrifft einen elektrische Leiter aufweisenden Träger mit einem elektronischen Bauteil, welches mit Kontaktwarzen die Leiter kontaktiert und auf dem Träger durch einen Kleber gehalten ist. Weiterhin betrifft die Erfindung ein Verfahren zum Kontaktieren von Leitern eines Substrates mit Kontaktwarzen eines elektronischen Bauteils.

Träger der vorstehenden Art mit mindestens einem elektronischen Bauteil kommen in der Elektronik sehr häufig vor. Zur Kontaktierung von IC und LCD bedient man sich derzeit der sogenannten FLIP-CHIP-Technologie. Dabei wird ein aus einem Wafer gesägter IC mit Bumps als Kontaktwarzen versehen und direkt auf eine LCD-Glaskantenfläche aufgebracht. Hierzu benetzt man die der Flüssigkristallzelle zugewandte Seite der Kontaktwarzen mit einem isotropen Epoxy-Kontaktkleber und drückt die IC's dann auf den Träger. Danach wird die Baueinheit aus Träger und IC's in einen Ofen zum Aushärten gebracht. Der Spalt zwischen dem jeweiligen elektronischen Bauteil und dem Träger muß anschließend mit einem Füllmaterial ausgefüllt werden, damit eine ausreichende mechanische Festigkeit erreicht und elektrische Migrationen vermieden werden.

Eine solche Kontaktierung ist wesentlich kostengünstiger als das am meisten bei der Kontaktierung von IC's mit LCD's verbreitete Tab Soldering, bei dem die Kontaktierung durch einen Lötvorgang erfolgt; sie ist jedoch immer noch relativ teuer und erfordert bei der Herstellung für die einzelnen Arbeitsgänge unerwünscht lange Taktzeiten. Kostengünstigere Kontaktierungen hat man bislang für Anwendungsfälle, bei denen mit großen Temperaturdifferenzen zu rechnen ist, beispielsweise für Kraftfahrzeuge, nicht gefunden, da die durch die Temperaturdifferenzen auftretenden, unterschiedlichen Dehnungen die Kontaktierung hoch beanspruchen.

Der Erfindung liegt das Problem zugrunde, einen Träger mit einem elektronischen Bauteil zu entwickeln, bei dem die Kontaktierung besonders kostengünstig herstellbar ist und die auch bei großen Temperaturschwankungen zuverlässig erhalten bleibt. Weiterhin soll ein Verfahren zur Kontaktierung eines solchen Bauteils mit dem Träger entwickelt werden.

Die erstgenannte Aufgabe wird erfindungsgemäß dadurch gelöst, daß die Kontaktwarzen an ihrer dem Träger zugewandten Seite eine Beschichtung mit einem im ausgehärteten Zustand elastisch bleibenden Graphitmaterial aufweisen, daß der Kleber den Spalt zwischen dem elektronischen Bauteil und dem Träger ausfüllt und daß das elektronische Bauteil durch den Kleber mit seinen Kontaktwarzen unter Vorspannung auf den Leitern des Trägers gehalten ist.

Bei einer solchen Anordnung eines elektronischen Bauteils auf einem Träger erfolgt die Kontaktierung der Leiter des Trägers durch eine Vorspannkraft des elektronischen Bauteils. Die hierzu erforderliche Elastizität wird durch das Graphitmaterial erreicht. Da das elektronische Bauteil als Ganzes auf dem Träger gehalten ist und nicht nur über die Kontaktwarzen, bleibt die Vorspannkraft auch nach langer Zeit noch erhalten und führt nicht zu einem Lösen des elektronischen Bauteils vom Träger. Wenn die Kleberschicht durch Erwärmung sich dehnt und deshalb dicker wird, nimmt der Abstand des elektronischen Bauteils vom Träger zwar zu, jedoch vermag das Graphitmaterial aufgrund der Vorspannung diese Abstandsänderung auszugleichen. Das Kleben hat gegenüber einem Lötvorgang den grundsätzlichen Vorteil, daß das elektronische Bauteil bei der Kontaktierung nicht durch höhere Temperaturen beansprucht wird. Zusätzlich wird durch ihn das bisher erforderliche Underfill-Material eingespart.

Besonders vorteilhaft ist es, wenn gemäß einer Weiterbildung der Erfindung der Träger transparent und der Kleber ein durch UV-Licht aushärtbarer Kleber ist. Man kann dann sehr einfach mit der Lichtquelle den Träger durchleuchten und dadurch den Kleber aushärten. Durch die unter der Wirkung des UV-Lichtes eintretende Polimerisation des Klebers, schrumpft dieser, was die Vorspannkraft zusätzlich erhöht.

Besonders vorteilhaft ist die Erfindung einzusetzen, wenn es sich bei dem Träger um eine LCD-Glaskantenfläche einer Flüssigkristallzelle handelt und das elektronische Bauteil ein direkt aus einem Wafer gesägtes IC (DIE) ist.

Die zweitgenannte Aufgabe, nämlich die Schaffung eines Verfahrens zum Kontaktieren von Leitern eines Trägers mit Kontaktwarzen eines elektronischen Bauteils, wird erfindungsgemäß dadurch gelöst, daß zunächst die Kontaktwarzen an ihrer dem Träger zugewandten Seite mit einem im ausgehärteten Zustand elastisch bleibenden Graphitmaterial beschichtet werden, daß dann Kleber auf das elektronische Bauteil zwischen den Kontaktwarzen oder entsprechend auf den Träger aufgebracht wird und anschließend das elektronische Bauteil unter Vorspannung so lange auf den Träger gedrückt wird, bis der Kleber ausgehärtet ist.

Ein solches Verfahren ist besonders kostengünstig auszuführen und ermöglicht durch die Vorspannkräfte zwischen dem elektronischen Bauteil und dem Träger eine besonders zuverlässige und von Temperaturschwankungen nicht beeinflußte Kontaktierung. Die Klebung hat gemäß der Erfindung eine Doppelfunktion. Sie hält das elektronische Bauteil auf dem Träger und verhindert zugleich, daß Feuchtigkeit und Verunreinigungen in den Spalt zwischen dem elektronischen Bauteil und dem Träger gelangen können, hat also die Funktion eines Underfills. Das Aufbringen des Klebers bereitet keine Schwierigkeiten. Er muß nicht sehr genau hinsichtlich seiner Lage und Menge bemessen werden. Selbst wenn Kleber auf die Kontaktwarzen oder Leiter gelangen sollte, hat das keine Bedeutung, weil er beim Andrücken des elektronischen Bauteils in den Kontaktierungsbereichen wieder weggedrückt würde.

Besonders vorteilhaft ist das Verfahren auszuführen, wenn gemäß einer Weiterbildung der Erfindung als Träger ein transparentes Material und als Kleber ein unter UV-Licht aushärtbarer Kleber benutzt wird, wobei das UV-Licht durch den Träger hindurch auf den Kleber gerichtet wird.

Die Erfindung läßt verschiedene Ausführungsformen zu. Zur weiteren Verdeutlichung ihres Grundprinzips wird nachfolgend auf die Zeichnung Bezug genommen. Diese zeigt in
- Fig.1: ein als DIE ausgebildetes, mit einem Träger zu verbindendes, elektronisches Bauteil,
- Fig.2: das Bauteil mit einer Beschichtung auf seinen Kontaktwarzen,
- Fig.3: einen Teil eines eine Flüssigkristallzelle bildenden Trägers mit dem elektronischen Bauteil.

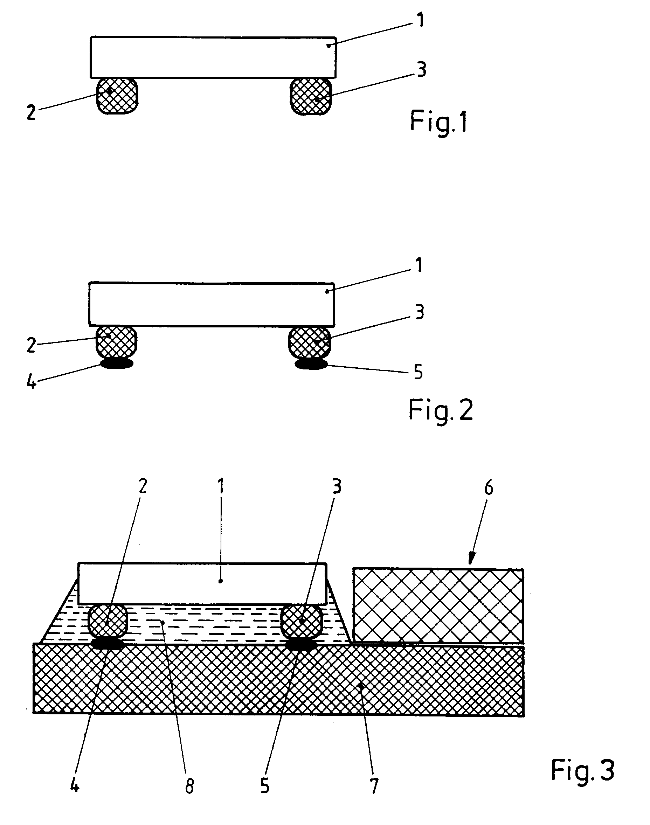

Die Figur 1 zeigt ein elektronisches Bauteil 1, welches an seiner Unterseite Kontaktwarzen 2, 3 hat, die vorzugsweise aus Gold bestehen und allgemein als Bumps bezeichnet werden. Bei diesem Bauteil handelt es sich um ein aus einem Wafer gesägtes IC (DIE), welches anschließend direkt auf ein zu kontaktierendes Medium - eine LCD-Glaskantenfläche - aufgebracht wird.

In Figur 2 ist das elektronische Bauteil 1 mit einer Beschichtung 4, 5 aus einem elastischen Graphitmaterial auf der Unterseite der Kontaktwarzen 2, 3 dargestellt.

In Figur 3 ist eine Flüssigkristallzelle 6 mit einem transparenten Träger 7 zu sehen. Dieser hat nicht zu erkennende Leiter, welche als ebenfalls transparente ITO-Schicht ausgebildet sind. Das elektronische Bauteil 1 sitzt mit seinen Kontaktwarzen 4, 5 unter Vorspannung auf den Leitern dieses Trägers 7 und wird in dieser Position durch einen Kleber 8 gehalten, welcher den gesamten Bereich zwischen dem Träger 7 und der Unterseite des elektronischen Bauteils 1 ausfüllt. Bei dem Kleber 8 handelt es sich um einen durch UV-Licht aushärtbaren Kleber, welcher vor dem Verbinden des elektronischen Bauteils 1 mit dem Träger 7 entweder als Tropfen zwischen die Kontaktwarzen 2, 3 oder auf den Träger 7 aufgebracht wird, so daß er sich beim Aufdrücken des elektronischen Bauteils 1 verteilt.

## Patentansprüche

1. Elektrische Leiter aufweisender Träger mit einem elektronischen Bauteil, welches mit Kontaktwarzen die Leiter kontaktiert und auf dem Träger durch einen Kleber gehalten ist, **dadurch gekennzeichnet**, daß die Kontaktwarzen (2, 3) an ihrer dem Träger (7) zugewandten Seite eine Beschichtung (4, 5) mit einem im ausgehärteten Zustand elastisch bleibenden Graphitmaterial aufweisen, daß der Kleber (8) den Spalt zwischen dem elektronischen Bauteil (1) und dem Träger (7) ausfüllt und daß das elektronische Bauteil (1) durch den Kleber (8) mit seinen Kontaktwarzen (2, 3) unter Vorspannung auf den Leitern des Trägers (7) gehalten ist.

2. Träger nach Anspruch 1, **dadurch gekennzeichnet**, daß er transparent und der Kleber (8) ein durch UV-Licht aushärtbarer Kleber (8) ist.

3. Träger nach Anspruch 2, **dadurch gekennzeichnet**, daß es sich bei ihm um eine LCD-Glaskantenfläche einer Flüssigkristallzelle (6) handelt und das elektronische Bauteil (1) ein direkt aus einem Wafer gesägtes IC (DIE) ist.

4. Verfahren zum Kontaktieren von Leitern eines Trägers mit Kontaktwarzen eines elektronischen Bauteils, bei dem das Bauteil durch Kleber auf dem Substrat gehalten wird, **dadurch gekennzeichnet**, daß zunächst die Kontaktwarzen an ihrer dem Träger zugewandten Seite mit einem im ausgehärteten Zustand elastisch bleibenden Graphitmaterial beschichtet werden, daß dann Kleber auf das elektronische Bauteil zwischen den Kontaktwarzen oder entsprechend auf den Träger aufgebracht wird und anschließend das elektronische Bauteil unter Vorspannung so lange auf den Träger gedrückt wird, bis der Kleber ausgehärtet ist.

5. Verfahren nach Anspruch 4, **dadurch gekennzeichnet**, daß als Träger ein transparentes Material und als Kleber ein unter UV-Licht aushärtbarer Kleber benutzt wird, wobei das UV-Licht durch den Träger hindurch auf den Kleber gerichtet wird.
